# FASCICULE DE BREVET EUROPEEN

(11) **EP 0 570 256 B1**
(45) Date de publication et mention de la délivrance du brevet: **11.03.1998**
(21) Numéro de dépôt: 93401147.9
(22) Date de dépôt: 04.05.1993
(51) Int. Cl.: H04B 1/04, H01Q 9/14, H03K 17/60

(54) **Inductance commutable pour forts courants, et circuit d'accord d'antenne muni d'au moins une telle inductance**
Schaltbare Hochleistungsinduktivität und Antennenanpassgerät mit einer solchen Induktivität
Switchable high current induction and antenna tuning circuit using the same

(30) Priorité: 12.05.1992 FR 9205722
(43) Date de publication de la demande: 18.11.1993
(73) Titulaire: THOMSON-CSF, 75008 Paris (FR)
(72) Inventeur: Wolk, Ivan, F-92402 Courbevoie Cedex (FR); Boulzaguet, Guy, F-92402 Courbevoie Cedex (FR)
(74) Mandataire: Courtellemont, Alain

(56) Documents cités:
- EP-A- 0 459 440
- DE-A- 2 050 994
- US-A- 3 602 788
- ELECTRONICS & WIRELESS WORLD vol. 12, no. 1599, Janvier 1986, LONDON pages 17 -
- 22 COOPER 'Remotely tunable antennas for frequency hopping'

## Description

La présente invention se rapporte aux inductances commutables pour forts courants, c'est-à-dire pour des courants de plusieurs dizaines voire plusieurs centaines d'ampères. L'invention a été développée dans le cadre des circuits d'accord d'antenne.

Quand une antenne est utilisée pour une émission au cours de laquelle sont effectués des sauts de fréquences, il est tentant d'utiliser une antenne sélective et de modifier son accord à chaque saut de fréquence pour toujours émettre dans des conditions optimales. C'est par exemple le cas pour une émission en modulation à minimum, aussi appelée modulation MSK (d'après le sigle de sa désignation dans la littérature anglo-saxonne : minimum-shift keying), c'est-à-dire pour une émission en modulation avec sauts d'une fréquence Fo - dF à une fréquence Fo + dF et inversement ; l'invention a d'ailleurs été conçue à l'origine pour émettre en mode MSK, dans des fréquences de l'ordre de 15 kHz et avec des puissances d'émetteur de l'ordre de plusieurs centaines de kilowatts.

Dans de telles conditions de fonctionnement des tentatives ont été effectuées pour réaliser l'accord avec l'enroulement primaire d'un transformateur à inductance saturable dont la valeur de l'inductance était réglée en saturant ou non le noyau magnétique au moyen d'une source de courant continu connectée aux bornes de l'enroulement secondaire et commandée au rythme de la modulation MSK. Malheureusement ce type de réalisation engendre des harmoniques de niveau important du fait que l'inductance commutable ainsi obtenue, fonctionne en des points où sa valeur ne varie pas de façon linéaire en fonction du courant radiofréquence ; or ces harmoniques sont très difficiles à filtrer.

La présente invention a pour but d'éviter ou pour le moins de réduire cet inconvénient.

Ceci est obtenu en utilisant un transformateur statique à air, c'est-à-dire avec bobinages mais sans noyau, dont le secondaire est mis alternativement en circuit ouvert et en court-circuit au rythme des sauts de fréquence.

Selon l'invention il est en particulier proposé une inductance commutable, pour forts courants, comportant un transformateur ayant un enroulement primaire qui constitue une inductance variable, caractérisé en ce que le transformateur est un transformateur statique à air et en ce qu'un système de commutation est branché entre la première et la seconde borne de l'enroulement secondaire du transformateur et un point à potentiel fixe, ce système comportant un premier et un second interrupteur, du type semi-conducteur à électrode de commande d'ouverture-fermeture, branchés de façon identique entre le point à potentiel fixe et respectivement les première et seconde bornes, et deux diodes branchées de façon identique entre le point à potentiel fixe et respectivement les première et seconde bornes, le sens de conduction des interrupteurs, quand ils sont commandés pour être ouverts, étant le même vu du point à potentiel fixe, le sens de conduction des diodes étant le même vu du point à potentiel fixe, mais le sens pour les diodes étant l'inverse de celui pour les interrupteurs.

La présente invention sera mieux comprise et d'autres caractéristiques apparaîtront à l'aide de la description ci-après et des figures s'y rapportant qui représentent :
- la figure 1, une antenne et un circuit d'adaptation d'antenne dans un schéma simplifié qui se rapporte aussi bien à l'art connu qu'à l'invention,
- la figure 2, un circuit d'adaptation d'antenne selon l'invention,
- la figure 3, une station d'émission avec un émetteur, un circuit d'adaptation d'antenne selon la figure 2 et une antenne.

Sur les différentes figures les éléments correspondants sont désignés par les mêmes repères.

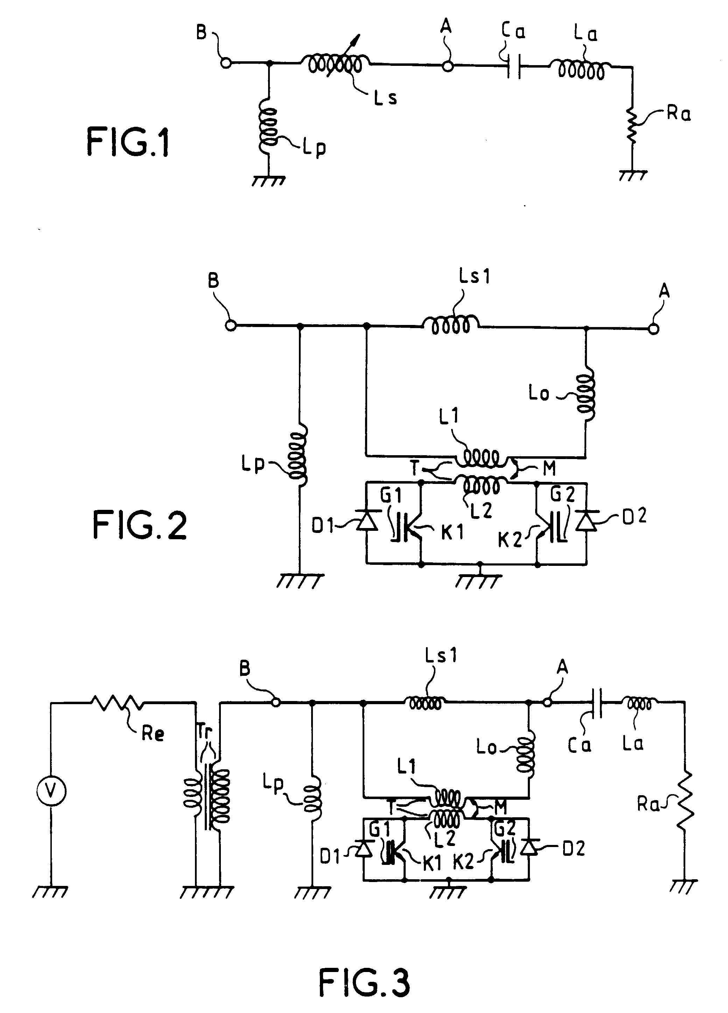

La figure 1 représente un schéma électrique équivalent d'une antenne et, connecté sur une borne, A, d'accès de l'antenne, un circuit d'adaptation de l'antenne. Le schéma électrique équivalent de l'antenne comporte, en série entre la borne A et la terre, un condensateur Ca, une inductance La et une résistance Ra.

Le circuit d'adaptation d'antenne de la figure 1 comporte deux inductances : une première inductance Ls branchée entre la borne A et une borne d'accès, B, et une seconde inductance Lp branchée entre la borne B et la masse ; la borne B est destinée à être reliée, à la sortie d'un émetteur. Ce circuit d'adaptation d'antenne est bien connu ; il est destiné à présenter, à un émetteur connecté à la borne B, une impédance purement ohmique. Si ce circuit est accordé à une fréquence Fo, l'ensemble circuit + antenne devient selfique à la fréquence Fo + dF, avec dF positif, et devient capacitif à la fréquence Fo - dF ; dans ces conditions, en modulation MSK, l'antenne n'est jamais accordée puisque les fréquences d'émission sont Fo + dF et Fo - dF. De manière à assurer l'accord aux fréquences Fo + dF et Fo - dF il est connu d'effectuer une commande dynamique de l'inductance Ls au rythme des sauts de fréquence, de telle sorte que l'accord soit toujours réalisé. Comme il a été indiqué plus avant, des inductances à commande dynamique ont été conçues à l'aide de transformateurs à inductance saturable, mais n'ont pas donné satisfaction en raison du fort taux d'harmoniques qu'ils produisent.

La figure 2 est le schéma électrique d'un circuit d'accord d'antenne avec, comme dans le cas de la figure 1, les bornes A et B, une inductance Lp montée entre la borne B et la masse et une inductance montée entre les bornes A et B. Cette inductance correspond à l'inductance Ls de la figure 1. Elle peut prendre deux valeurs distinctes et comporte : une première inductance Ls1 connectée entre les bornes A et B, une deuxième inductance Lo dont une première extrémité est reliée à la borne A, un transformateur statique à air, T, dont l'enroulement primaire constitue une inductance L1 qui a une première borne reliée directement à la borne B et une seconde borne reliée à la borne A à travers l'inductance Lo, et un système de commutation branché entre la première et la seconde borne de l'enroulement secondaire du transformateur T et la masse. Le système de commutation comporte un premier, K1, et un second, K2, interrupteur du type semi-conducteur à électrode de commande d'ouverture-fermeture, et une première, D1, et une seconde, D2, diode. Dans l'exemple décrit les interrupteurs sont des éléments connus sous le nom de IGBT, d'après les initiales de leur désignation dans la littérature anglo-saxonne : Insulated Gate Bipolar Transistors ; ces IGBT permettent de couper de très forts courants avec une tension de commande très faible. Les IGBT K1 et K2 ont leurs collecteurs respectivement reliés à la première et à la seconde extrémité de l'enroulement secondaire du transformateur T et leurs émetteurs reliés à la masse ; de même les diodes D1 et D2 ont leurs cathodes respectivement reliées à la première et à la seconde extrémité de l'enroulement secondaire du transformateur T et leurs anodes reliées à la masse. Tel que le système de commutation est monté, si les IGBT, K1, K2, sont bloqués par une commande externe appliquée sur leurs portes G1, G2, l'enroulement secondaire du transformateur T est ouvert car les diodes D1, D2, polarisées en inverse sont bloquées. Par contre quand les IGBT, K1, K2 sont rendus passants par la commande externe, l'enroulement secondaire du transformateur T est en court-circuit ; en effet le courant circule de K1 vers D2 lors d'une alternance et de K2 vers D1 lors de l'autre l'alternance.

Ainsi, pour travailler à la fréquence Fo - dF, l'enroulement secondaire du transformateur T est ouvert, l'inductance Ls entre les points A et B est alors constituée par la mise en parallèle de l'inductance Ls1 et des inductances Lo et L1 en série. Et, pour travailler à la fréquence Fo + dF, l'enroulement secondaire du transformateur T est mis en court-circuit ; l'inductance Ls entre les bornes A et B est alors constituée par la mise en parallèle de l'inductance Ls1 et de deux inductances en série : l'inductance Lo et l'inductance (1 - k²)L1, où k est le coefficient de couplage entre les enroulements primaire et secondaire du transformateur T et où k² vaut M²/L1.L2, M désignant la mutuelle inductance entre les deux enroulements et L1 et L2 les inductances respectives des deux enroulements.

Il est à remarquer que l'enroulement primaire du transformateur T pourrait être disposé directement entre les bornes A et B mais que, dans l'exemple décrit, afin de réduire le courant dans le système de commutation, un diviseur de courant a été réalisé à l'aide des inductances Ls1, L1 et Lo dont les valeurs sont ajustées en fonction des courants à ne pas dépasser dans les IGBT et dans les diodes et en fonction des deux valeurs d'inductance à obtenir entre les bornes A et B.

Le circuit selon la figure 2 peut donc être utilisé comme circuit d'accord d'antenne dans une station d'émission travaillant par sauts de fréquences ; il suffit, pour cela de commander l'ouverture et la fermeture des IGBT au rythme des sauts de fréquence. Et il est à noter que pour une émission à effectuer sur un nombre de fréquences distinctes supérieur à deux il suffit de mettre en série plusieurs inductances commutables pour constituer le circuit d'accord d'antenne et de commander les différents systèmes de commutation en fonction des fréquences d'émission, au rythme des sauts de fréquence.

Parmi les avantages du système de commutation selon la figure 2 il faut noter en particulier : la linéarité de fonctionnement, l'absence de signaux parasites dus à la commutation, et la transmission du spectre sans distorsion.

La figure 3 montre le circuit selon la figure 2 utilisé en circuit d'adaptation d'antenne entre un émetteur connecté à sa borne B et une antenne représentée, comme sur la figure 1, par son schéma électrique Ca, La, Ra. L'émetteur qui est assimilable à une source de tension V et qui présente une résistance interne Re, a, dans l'exemple décrit, une sortie par transformateur, Tr, de rapport 2.

La réalisation selon la figure 3 a été conçue pour un fonctionnement en mode MSK4 avec
Fo = 15,1 kHz et dF = 50 Hz,
et avec
V = 23.255 volts crête
Re = 40 ohms
Lp = 154,92 µH
Ls1 = 645,80 µH
L1 = L2 = 397,06 µH
M = 397,06 µH
L0 = 2,825 mH
Ca = 130 nF
La = 168,36 nH
Ra = 0,216 ohms
et les courants observés en régime nominal sont de
62 et 31A crête respectivement dans les enroulements primaire et secondaire du transformateur Tr,
3200 A crête dans l'inductance Lp,
3050 A crête dans l'antenne,
400A crête dans les IGBT K1 et K2.

## Revendications

1. Inductance commutable, pour forts courants, comportant un transformateur ayant un enroulement primaire qui constitue une inductance variable, caractérisé en ce que le transformateur (T) est un transformateur statique à air et en ce qu'un système de commutation (K1, K2, D1, D2) est branché entre la première et la seconde borne de l'enroulement secondaire (L2) du transformateur et un point à potentiel fixe, ce système comportant un premier (K1) et un second (K2) interrupteur, du type semi-conducteur à électrode de commande d'ouverture-fermeture, branchés de façon identique entre le point à potentiel fixe et respectivement les première et seconde bornes, et deux diodes (D1, D2) branchées de façon identique entre le point à potentiel fixe et respectivement les première et seconde bornes, le sens de conduction des interrupteurs, quand ils sont commandés pour être ouverts, étant le même vu du point à potentiel fixe, le sens de conduction des diodes étant le même vu du point à potentiel fixe, mais le sens pour les diodes étant l'inverse de celui pour les interrupteurs.

2. Inductance commutable selon la revendication 1, comportant deux bornes d'accès (A, B), caractérisée en ce qu'elle comporte une inductance de valeur donnée (Ls1) et en ce que les deux bornes d'accès sont reliées par deux trajets dont l'un comporte l'enroulement primaire (L1) du transformateur (T) et l'autre l'inductance de valeur donnée (Ls1).

3. Inductance commutable selon l'une des revendications précédentes, caractérisée en ce que les interrupteurs (K1, K2) sont des IGBT.

4. Circuit d'accord d'antenne, caractérisé en ce qu'il comporte au moins une inductance commutable selon l'une des revendications précédentes.

## Patentansprüche

1. Umschaltbare Induktivität für starke Ströme mit einem Transformator, dessen Primärwicklung eine variable Induktivität bildet, dadurch gekennzeichnet, daß der Transformator (T) ein statischer Lufttransformator ist und daß ein Umschaltsystem (K1, K2, D1, D2) zwischen die beiden Klemmen der Sekundärwicklung (L2) des Transformators und einen Punkt festen Potentials eingefügt ist, das einen ersten und einen zweiten Unterbrecher (K1, K2) vom Halbleitertyp mit einer Steuerelektrode vom Leit-/Sperrtyp, wobei die Unterbrecher in gleicher Weise zwischen den Punkt festen Potentials und die erste beziehungsweise zweite Klemme eingefügt sind, und zwei Dioden (D1, D2) besitzt, die in gleicher Weise zwischen den Punkt festen Potentials und die erste beziehungsweise zweite Klemme eingefügt sind, wobei die Leitrichtung der Unterbrecher, wenn sie leitend gesteuert sind, aus der Sicht des Punkts festen Potentials die gleiche ist und die Leitrichtung der Dioden aus der Sicht des Punkts festen Potentials die gleiche ist und wobei aber die Leitrichtung für die Dioden der für die Unterbrecher entgegengesetzt ist.

2. Umschaltbare Induktivität nach Anspruch 1 mit zwei Zugangsklemmen (A, B), dadurch gekennzeichnet, daß sie eine Induktivität eines gegebenen Werts (Lsl) besitzt und daß die beiden Zugangsklemmen über zwei Wege miteinander verbunden sind, von denen der eine die Primärwicklung (L1) des Transformators (T) und der andere die Induktivität eines gegebenen Werts (Ls1) enthält.

3. Umschaltbare Induktivität nach einem der vorstehenden Ansprüche, dadurch gekennzeichnet, daß die Unterbrecher (K1, K2) vom IGBT-Typ (Insulated Gate Bipolar Transistor) sind.

4. Antennenabstimmschaltung, dadurch gekennzeichnet, daß sie mindestens eine umschaltbare Induktivität nach einem der vorstehenden Ansprüche enthält.

## Claims

1. Switchable inductor, for strong currents, comprising a transformer having a primary winding which constitutes a variable inductor, characterized in that the transformer (T) is an air-core static transformer and in that a switching system (K1, K2, D1, D2) is wired between the first and the second terminal of the secondary winding (L2) of the transformer and a point at fixed potential, this system comprising a first (K1) and a second (K2) breaker, of the semiconductor type with open-close control electrode, these being wired in an identical fashion between the point at fixed potential and the first and second terminals respectively, and two diodes (D1, D2) wired in an identical fashion between the point at fixed potential and the first and second terminals respectively, the direction of conduction of the breakers, when they are operated so as to open, being the same when seen from the point at fixed potential, the direction of conduction of the diodes being the same when seen from the point at fixed potential, but the direction for the diodes being the reverse of that for the breakers.

2. Switchable inductor according to Claim 1, comprising two access terminals (A, B), characterized in that it comprises an inductor of given value (Ls1) and in that the two access terminals are linked by two paths, one of which comprises the primary winding (L1) of the transformer (T) and the other the inductor of given value (Ls1).

3. Switchable inductor according to one of the preceding claims, characterized in that the breakers (K1, K2) are IGBTs.

4. Antenna tuning circuit, characterized in that it comprises at least one switchable inductor according to one of the preceding claims.
